# EUROPEAN PATENT APPLICATION

(11) **EP 2 626 891 A2**
(43) Date of publication of application: **14.08.2013**
(21) Application number: 13154156.7
(22) Date of filing: 06.02.2013
(51) Int. Cl.: H01L 21/285, H01L 21/02, H01L 31/0224

(54) **Activation process to improve metal adhesion**

(30) Priority: 07.02.2012 US 201261596008 P
(71) Applicant: Rohm and Haas Electronic Materials LLC, Marlborough, MA 01752 (US)
(72) Inventor: Wei, Lingyun, Shrewsbury, MA 01545 (US); Hamm, Gary, Billerica, MA 01821 (US)
(74) Representative: Buckley, Guy Julian

(57) **Abstract**

Native oxide removing and activating solutions containing fluoride ions and organic acids are used in the formation of metal layers on semiconductor wafers. The method may also be used in the formation of silicides and for preparing the metal silicides for additional metal plating and build-up. The solutions and methods may be used in the manufacture of photovoltaic devices and other electronic devices and components.

## Description

### Field of the Invention

The present invention is directed to an activation process to improve metal adhesion to a substrate containing silicon. More specifically, the present invention is directed to an activation process to improve metal adhesion to a substrate containing silicon using an aqueous composition composed of fluoride ions and organic acids.

### Background of the Invention

Metal containing silicon semiconductors have a wide variety of uses in advanced packaging technologies, such as forming gate electrodes, ohmic contacts, interconnection lines, Schottky barrier diode contacts, photovoltaics, solar cells and optoelectronic components. The silicon semiconductors may be metallized by various processes, such as electroplating, electroless plating, immersion plating, light induced plating or by various physical and chemical vapor deposition processes. However, achieving good metal adhesion on the silicon suitable for commercial products is one of the most challenging problems due to the formation of native oxide on the silicon or metal oxides if the deposited metal is annealed to form a metal silicide with additional metal build up on the metal silicide.

After annealing metal layers are typically deposited on the metal silicide to build-up and form conductive tracks or electrodes. Typically the silicide must be activated prior to depositing such metal layers. Activation may be done by deposition of catalytic material on the silicide; however, this requires additional multiple steps to the overall process or use of catalytic colloid compounds. Catalytic colloid compounds may adhere to dielectric materials selectively coated onto the silicon and result in undesired, excessive, and non-selective deposition of metal on the dielectric. Non-selective deposition of metal may lead to surface contamination, unwanted diffusion of conductive materials into dielectric materials, and even device failure from short circuits and other device irregularities. This not only increases the number of processing steps but whenever an activation step is included prior to metallization there is a risk of not properly activating the metal layer, thus resulting in adhesion failure between metal layers.

U.S. 6,787,450 discloses a method of forming silicides on semiconductor devices and using electroless metal deposition to form conductors. The semiconductors may be silicon based, silicon-germanium, germanium or gallium arsenide. The semiconductor material is selectively coated with an insulating layer leaving exposed regions of the semiconductor. A layer of titanium is deposited on the exposed semiconductor by chemical vapor deposition and the semiconductor is heat annealed to temperatures high enough to form titanium silicide. In addition to titanium, other metals such as tungsten, cobalt and nickel may be used to form the silicide.

After annealing the silicide is activated prior to depositing metal layers on the silcide. Activation removes oxides and oxide-containing compounds from the titanium silicide. Such oxides compromise metal adhesion to the silicide and ultimately compromise the reliability of any electronic device in which the semiconductor is used. Activation may be done with an etching solution containing ammonium peroxide, hydrofluoric acid (HF) alone or a mixture of HF and palladium chloride. Various surfactants may also be included in the activation solution. If cobalt or nickel silicide is formed instead of titanium silicide, it is also necessary to activate the silicides prior to electroless build-up to form the conductor. After activation, the semiconductor is rinsed and then electrolessly plated with nickel, nickel alloy, cobalt or cobalt alloy to form the conductor.

Although HF is one or the most common activation formulations for removing native oxides and preparing silicon and silicides for metallization, it attacks or corrodes metal paste electrodes, such as aluminum paste electrodes as well as antireflective layers found in many photovoltaic devices. Such corrosion is typical when the antireflective layers are silicon nitride or silicon oxide/silicon nitride composites. Accordingly, there is a need for a method of removing native oxide, activating silicon and metal silicides and enabling good metal adhesion without damaging the antireflective layer and substantially corroding aluminum electrodes.

### Summary of the invention

Methods include providing a substrate which includes silicon; removing native oxide from a surface of the silicon substrate with an aqueous activating composition composed of one or more sources of fluoride ions and one or more organic acids; and depositing a metal layer on the substrate where the native oxide is removed. The metal layer may then be built up by depositing one or more additional metal layers. Alternatively, the initial metal layer and the substrate may be sintered to form a metal silicide. The silicide is then treated with the aqueous activation composition composed of one or more sources of fluoride ions and one or more organic acids. Additional metal layers may then be deposited on the activated metal silicide.

The compositions are substantially free of HF thus they do not substantially corrode antireflective coatings of silicon nitride and silicon oxide/silicon nitride composites, such as are found in photovoltaic devices. The aqueous compositions also do not substantially corrode aluminum electrodes which are components of many photovoltaic devices. The activation compositions enable improved metal adhesion to silicon containing substrates and metal silicides in contrast to many conventional methods.

### Detailed Description of the Invention

As used throughout this specification, the terms "depositing" and "plating" are used interchangeably. The terms "current tracks" and "current lines" are used interchangeably. The terms "composition" and "bath" are used interchangeably. The indefinite articles "a" and "an" are intended to include both the singular and the plural. The term "silicide" means a binary compound of silicon and another element, usually a metal. The term "selectively depositing" means that deposition occurs in specific desired areas on a substrate. The following abbreviations have the following meanings unless the context clearly indicates otherwise: °C = degrees Celsius; g = grams; ml = milliliter; L = liter; A = amperes; m = meters; dm = decimeter; cm = centimeter; µm = microns; nm = nanometers; s = seconds; UV = ultraviolet; N = Newton = 1kgm/s²; IR = infrared; LED = light emitting diode; LIP = light induced plating. All percentages and ratios are by weight unless otherwise indicated. All ranges are inclusive and combinable in any order except where it is logical that such numerical ranges are constrained to add up to 100%.

Photovoltaics and solar cells may be composed of monocrystalline or polycrystalline or amorphous silicon containing semiconductor wafers. Such wafers typically have a p-type base doping. The semiconductor wafers may be circular, square or rectangular in shape or may be any other suitable shape. Such wafers may have a wide variety of dimensions and surface resistivities.

The back side of a wafer is metallized to provide a low resistance wafer. Conventional methods may be used. The entire back side may be metal coated or a portion of the back side may be metal coated, such as to form a grid. Such back side metallization may be provided by a variety of techniques, and may be done prior to the metallization of the front side of the wafer. A metal coating may be applied to the back side in the form of an electrically conductive paste, such as a silver-containing paste, an aluminum-containing paste or a silver and aluminum-containing paste; however, other suitable pastes known in the art also may be used. Such conductive pastes typically include conductive particles embedded in a glass matrix and an organic binder. Conductive pastes may be applied to the wafer by a variety of techniques, such as screen printing. After the paste is applied, it is fired to remove the organic binder. When a conductive paste containing aluminum is used, the aluminum partially diffuses into the back side of the wafer, or if used in a paste also containing silver, may alloy with the silver. Use of such aluminum-containing paste may improve the resistive contact and provide a "p+"-doped region. Heavily doped "p+"-type regions by previous application of aluminum or boron with subsequent interdiffusion may also be produced.

The front side of the wafer may optionally be subjected to crystal-oriented texture etching in order to impart to the surface an improved light incidence geometry which reduces reflections. This may be done by contacting the semiconductor wafer with acid, such as hydrofluoric acid, or alkali to texture or roughen the surface.

To produce the semiconductor junction, phosphorus diffusion or ion implantation takes place on the front side of the wafer to produce an n-doped (n+ or n++) region and provides the wafer with a PN junction. The n-doped region may be referred to as the emitter layer.

An anti-reflective layer is added to the front side or emitter layer of the wafer. In addition the anti-reflective layer may serve as a passivation layer. Typically anti-reflective layers include, without limitation, silicon nitride layers such as Si₃N₄ or a combination of silicon oxide and silicon nitride layers. Such anti-reflective layers may be deposited by a number of techniques, such as by various vapor deposition methods, for example, chemical vapor deposition and physical vapor deposition.

The front side of a wafer contains a pattern for metallization. For example, the front side of a wafer may be composed of current collecting lines and current busbars. Current collecting lines are typically transverse to the busbars and typically have a relatively fine-structure (i.e. dimensions) relative to current busbars.

The pattern reaches through the antireflective layer to expose the surface of the semiconductor body of the wafer. Alternatively trenches may be formed in the openings to create a selective emitter. These trenches may be regions of high doping. A variety of processes may be used to form the pattern, such as, but not limited to, laser ablation, mechanical means, and lithographic processes, all of which are well known in the art. Such mechanical means include sawing and scratching.

When surface oxides or native oxides are present on the wafer they are removed from the conductive pattern prior to metallization using an aqueous composition composed of one or more sources of fluoride ions and one or more organic acids. The pH of the composition ranges from 3 to less than 7, preferably from 3 to 6 and more preferably from 4 to 5. The aqueous compositions are free of HF, thus they eliminate or reduce corrosion of the antireflective layers and of aluminum electrodes, typically found on photovoltaic devices and solar cells, is also prevented or at least inhibited. Preferably, the aqueous composition is applied to the wafer after the antireflective layer is applied and the current tracks have been formed in the antireflective layer exposing the wafer surface. The composition may be applied by spraying the wafers or immersing the wafers into the composition. The aqueous composition may be applied from 30 seconds to 3 minutes, preferably from 1-2 minutes. In addition to removing the native oxide, the aqueous compositions activate the silicon for metal plating which otherwise may not receive the metal deposit.

Fluoride ion sources include, but are not limited to, alkali metal fluorides, such as potassium fluoride and sodium fluoride, ammonium fluoride, metal salts such as antimony (III/VI) fluoride, barium fluoride, tin (II) fluoride, aluminum (III) fluoride, fluoroborate compounds, tetramethylammonium fluoride as well as other compounds which can dissociate a fluoride ion in an aqueous media. Such additional fluoride compounds include, but are not limited to, fluoride salts of aliphatic primary, secondary and tertiary amines such as compounds which have a general formula:

R₁N(R₃)R₂

wherein R₁, R₂ and R₃ each individually represents H or an alkyl group of 1-12 carbon atoms. Bifluorides, however, are not suitable as fluoride ion sources since they may generate HF acid which may corrode both the antireflective layer and aluminum containing electrodes. In general, the sources of fluoride ions are included in the aqueous composition in amounts of 10 g/L to 60 g/L, preferably from 20 g/L to 40 g/L.

One or more organic acids include, but are not limited to polycarboxylic acids and hydroxycarboxylic acids. Polycarboxylic acids include, but are not limited to, dicarboxylic acids such as oxalic acid, malonic acid, succinic acid, glutaric acid, adipic acid, maleic acid, and fumaric acid. Hydroxylcarboxylic acids include, but are not limited to, malic acid, tartaric acid and citric acid. Only the acids and not the salts of the acids may be used. Salts of organic acids are excluded from the native oxide removing composition. The organic acids are included in the native oxide removing composition in amounts of 1g/L to 30 g/L, preferably from 5 g/L to 20 g/L.

The aqueous compositions are applied at temperatures from room temperature to 60° C. Preferably, the aqueous compositions are applied from room temperature to 30° C.

A metal seed layer is promptly deposited on the front side conductive pattern. The metal seed layer may be deposited by any conventional metal deposition method known in the art, such as electroplating, electroless plating, immersion plating, LIP or light assisted plating. Conventional process parameters may be used to deposit the metal seed layer. Some minor experimentation may be required to tailor the parameters of the metal deposition processes for a particular semiconductor wafer and metal. Typically, the metal seed layer is deposited by electroplating, electroless plating and LIP. More typically, the metal seed layer is deposited by electrolytic plating and LIP. When LIP or light assisted plating is used, if the source of the metal is an electroless bath, plating is done without application of external current. If the source of the metal is from an electrolytic metal bath, a rear side potential (rectifier) is applied to the semiconductor wafer substrate. The light may be continuous or pulsed. Light which may be used includes, but is not limited to, visible light, IR, UV and X-rays. Light sources include, but are not limited to, incandescent lamps, such as a 75 watt and 250 watt lamp, LEDs, IR lamps, such as a150 watt IR lamp, fluorescent lamps, halogen lamps and lasers.

Metals which may be deposited as seed layers include, but are not limited to, nickel, cobalt, palladium, platinum, rhodium and alloys of the metals. Preferably nickel, cobalt, palladium and platinum are deposited on the current tracks as seed layers. More preferably, nickel and cobalt are deposited. Most preferably nickel is deposited on the current tracks as a seed layer. When the metal or metal alloy is deposited by electroplating, electroless plating, immersion plating, LIP or light assisted plating, the source of the metals is provided as one or more water-soluble metal compounds. Such water-soluble metal compounds include, but are not limited to, metal sulfates, metal halides, such as metal chlorides and bromides, metal sulfamates, metal phosphates, metal oxides, metal hydroxides, metal cyanides and metal nitrates. Such metal salts are generally commercially available from a variety of sources, such as Aldrich Chemical Company, Milwaukee, Wisconsin.

Conventional metal plating baths known in the art and disclosed in the literature may be used, such as the Watts-type electrolytic nickel plating baths disclosed in U.S. 3,041,255. Examples of commercially available nickel baths are NICKEL GLEAM™ Electrolytic Nickel products, ENLIGHT™ 1300 Electrolytic Nickel plating solution, ENLIGHT™ 710, 720 and 730 Electroless Nickel plating solutions (NICKEL GLEAM™ and ENLIGHT™ plating products are all available from Rohm and Haas Electronic Materials, LLC).

Any of a wide variety of electrolytes may be used in the metal plating baths, including acids and bases. Exemplary electrolytes include, without limitation, alkane sulfonic acids such as methane sulfonic acid, ethane sulfonic acid and propane sulfonic acid; alkylol sulfonic acids; aryl sulfonic acids such as toluene sulfonic acid, phenyl sulfonic acid and phenol sulfonic acid; amino-containing sulfonic acids such as amido sulfonic acid; sulfamic acid; mineral acids; carboxylic acids such as formic acid and haloacetic acids; hydrogen halide acids; and pyrophosphate. Salts of acids and bases also may be used as the electrolyte. Further, the electrolyte may contain a mixture of acids, a mixture of bases or a mixture of one or more acids with one or more bases. Such electrolytes are generally commercially available from a variety of sources, such as Aldrich Chemical Company, Milwaukee, Wisconsin.

A wide variety of conventional additives may be included on the metal plating baths. Such additives include, but are not limited to, surfactants, such as anionic, cationic, amphoteric and nonionic surfactants, brighteners, grain refiners, ductility enhancers, complexing agents, chelating agents, buffering agent, such as borate buffer, phosphate buffer, citrate buffer, carbonate buffer, and hydroxide buffer. The amount of the buffer used is that amount sufficient to maintain the pH of the plating at a desired level, such amount being well known to those skilled in the art. If the metal plating bath is an electroless bath it typically includes one or more reducing agents. Such reducing agents include, but are not limited to sodium hypophosphite, potassium hypophosphite, thiourea and thiourea derivatives, hydantoin and hydantoin derivatives, hydroquinone and hydroquinone derivatives, resorcinol, and formaldehyde and formaldehyde derivatives, DEA (n-diethyl-amine borane), sodium borohydride and hydrazine. Such additives are generally commercially available from a variety of sources, such as Aldrich Chemical Company, Milwaukee, Wisconsin.

When the metal seed layer is deposited by electroplating, a rear side potential (rectifier) is applied to the wafer. The electroplating processes used are conventional. In general, current densities are from 0.1 A/dm² to 2 A/dm², and typically from 0.5 A/dm² to 1.5 A/dm². The particular current requirement is dependent upon the particular size of the wafer used and the metal to be electroplated.

When the metal seed layer is plated by LIP or light assisted plating the front of the semiconductor wafer is illuminated with light energy and plating occurs on the front. The impinging light energy generates a current in the semiconductor. The rate of plating on the front is controllable by adjusting the light intensity, bath temperature, reducing agent activity, starting wafer conditions, doping level as well as other parameters which are known to workers in the art. If the plating bath is an electroplating bath, the rate of plating may also be adjusted by the rectifier. A metal layer of 20nm to 300nm thickness, or such as from 50nm to 150nm is typically desired, with the exact thickness depending on various factors such as on the application, size, pattern and geometry.

After the seed layer metal is deposited adjacent the silicon of the semiconductor wafer, one or more additional metal layers may be deposited on the seed layer. Such metal layers may be the same metal as the seed layer or a different metal. Such metals include, but are not limited to, nickel, cobalt, silver, copper, platinum, palladium, rhodium, gold, tin and alloys thereof. Preferably the metal adjacent the seed layer is the same type of metal as the seed layer. Such metals may be deposited on the seed layer using the conventional plating processes described above as well as conventional metal plating baths. Alternatively, after the seed layer is deposited adjacent the silicon, the wafer is sintered to form metal silicide. Conventional sintering methods may be used to form the silicide. Sintering may be performed by heating the wafer to a fixed temperature for a specific duration or by ramping the wafer temperature from room temperature to a specific peak temperature. Typically a furnace providing a wafer peak temperature of 300° C or greater or from 400° C to 550° C is used. Typically, peak temperature times range from 2 seconds to 20 seconds, or such as from 5 seconds to 15 seconds. An example of a suitable furnace is a lamp based furnace (IR).

In general, fixed temperature sintering is done for at least 3 minutes, or such as from 4 minutes to 10 minutes. Line speeds at which the semiconductor passes through the furnace may vary depending on the furnace used. Minor experimentation may be done to determine the appropriate line speed. Typically, the line speed is from 330 cm/minute to 430 cm/minute, or such as from 370 cm/minute to 420 cm/minute.

After the metal silicide is formed, it may be stripped of any unreactive metal. Stripping may be done using an acid stripping solution, such as 20-40% nitric acid which is typically used to strip nickel. The metal silicide is then activated with an aqueous composition composed of one or more sources of fluoride ions and one or more organic acids as described above. Activation removes native and metal oxides on the silicide. The aqueous activating composition may be applied from 30 seconds to 3 minutes, preferably from 1-2 minutes and under the same temperature conditions as described above.

Immediately following activation, without any intervening steps, an additional metal layer is deposited adjacent the metal silicide. Such metals include, but are not limited to silver, nickel, cobalt, palladium, platinum, copper rhodium, gold, tin and alloys thereof. The metal which is deposited adjacent the metal silicide may be the same metal as the metal of the silicide or it may be a different metal. For example if the silicide is a cobalt silicide nickel may be plated adjacent the cobalt silicide as opposed to cobalt. Preferably, the metal which is deposited adjacent the metal silicide is the same type of metal which is used to form the metal silicide. For example, if the metal silicide is a nickel silicide, the metal deposited adjacent the nickel silicide is preferably nickel and if the metal silicide is cobalt silicide, cobalt is deposited adjacent the silicide. The metal may be deposited using the same type of methods used to deposit the metal for the formation of the metal silicide. Typically, the metal is deposited adjacent the metal silicide by electroplating, electroless plating, immersion plating, LIP or light assisted plating. Preferably, the metal is deposited adjacent the metal silicide by electroplating and LIP.

In general, the metal layer deposited adjacent the metal seed layer or the metal silicide is 0.5µm to 50µm thick. Preferably, the metal layer is 1µm to 2µm thick. One or more additional metal layers of different metals may then be plated on the metal layer adjacent the metal silicide or seed layer. Such metals have thickness ranges of 0.5µm to 50µm, preferably from 5µm to 20µm. Preferred metals include copper, silver, tin and tin/lead alloys. The more preferred metals are copper and silver and tin. The most preferred are copper and silver. Typically copper has a silver or tin capping layer. Optionally, the last layer of metal can be coated with conventional organic solderability preservatives. Conventional metal plating baths may be used as well as conventional metal depositing parameters. An example of a commercially available copper plating bath is ENLIGHT™ 460 Copper Electroplating solution When electroplating is used to deposit the metal, current densities may range from 0.1 A/dm² to 10 A/dm².

When the final metal layer for forming the current tracks and bus bars is silver, the silver metal layer may range from 0.5µm to 10µm thick. Preferably, the silver layer is 1µm to 5µm thick. The silver may be deposited by conventional methods, such as electroplating, electroless plating, immersion plating, LIP or light assisted plating. Preferably, silver is deposited on the current tracks and bus bars by electroplating, electroless plating, LIP or light assisted plating. More preferably, silver is deposited on the current tracks and bus bar by electroplating and LIP.

Conventional silver plating baths may be used. The silver baths may be cyanide containing or cyanide-free silver baths. Sources of silver ions include, without limitation: silver potassium cyanide, silver nitrate, silver sodium thiosulfate, silver gluconate; silver-amino acid complexes such as silver-cysteine complexes; silver alkyl sulfonates, such as silver methane sulfonate. Mixtures of silver compounds may be used, such as a mixture of silver nitrate and silver-cysteine complex. The concentration of silver ions in the composition is typically in conventional amounts, such as 2 g/L to 40 g/L. Such silver compounds are generally commercially available from a variety of sources, such as Aldrich Chemical Company, Milwaukee, Wisconsin. Examples of commercially useful silver plating compositions are available as ENLIGHT^{™} Silver Plate 600 and 620 plating solutions.

A wide variety of conventional surfactants may be used in the silver plating baths, such as anionic, cationic, amphoteric and nonionic surfactants. Surfactants may be included in conventional amounts. The silver plating baths may contain one or more additional conventional components. Such additional components include, without limitation, electrolytes, buffers, brighteners, grain refiners, chelating agents, complexing agents, reducing agents, levelers and ductility enhancers. Such additional components are well known in the art and are used in conventional amounts. Such additives are generally commercially available from a variety of sources, such as Aldrich Chemical Company, Milwaukee, Wisconsin.

Silver plating compositions may have a pH in the range of 1 to 14, typically from 1 to 12, and still more typically from 8 to 10. The working temperature of the plating compositions during metal plating may be from 10 to 100 °C, or such as from 20 to 60 °C. Typically the working temperature is in the range of 30 to 40 °C, and more typically from 35 to 40 °C. When the silver is electroplated, typical current densities are from 0.1 A/dm² to 5 A/dm², and more typically from 1 A/dm² to 3 A/dm².

Optionally, the semiconductor wafer may be edge isolated prior to metallization. Edge isolation reduces the probability of shunting the semiconductor wafer during metallization due to bridging of metal deposits from the n-type emitter layer to the p-type layer of the semiconductor wafer. Edge isolation may be done by applying tape or a conventional plating resist, i.e., edge mask, along the edge of the semiconductor wafer prior to metallization. Such plating resists may be a wax based composition which includes one or more waxes, such as montan wax, paraffin wax, soy, vegetable waxes and animal waxes. In addition, such resists may include one or more cross-linking agents, such as conventional acrylates, diacrylates and triacrylates, and one or more curing agents to cure the resist upon exposure to radiation, such UV and visible light. Curing agents include, but are not limited to, conventional photoinitiators used in photoresists and other photosensitive compositions. Such photoinitiators are well known in the art and published in the literature. Such plating resists may be applied by conventional screen printing procedures or by selective ink jet processes. Alternatively, the semiconductor wafer may be edge isolated with the antireflective layer. This may be done by depositing the material used to make the antireflective layer on the edges of the semiconductor layer during formation of the antireflective layer.

The methods of removing native oxide and activating silicon and metal silicides before metal deposition enable good and improved adhesion of the metal layers to the semiconductor wafer in view of many conventional methods of metal deposition in the manufacture of photovoltaic devices. The aqueous fluoride ion and organic acid activating compositions are free of HF thus they do not corrode antireflective layers and do not substantially corrode aluminum electrodes. The native oxide removal method and activation method have been described with particular reference to silicon semiconductor wafers used in photovoltaic devices and solar cells; however, the methods may be used in the manufacture of components for other articles, such as gate electrodes, ohmic contacts, interconnection lines, Schottky barrier diode contacts and optoelectronic components.

The following examples are included to illustrate the invention but are not intended to limit the scope of the invention.

### Example 1 (comparative)

Four monocrystalline silicon wafers coated with dark blue silicon nitride antireflective layer on one side were provided. Two wafers were immersed into 1wt% aqueous hydrofluoric acid. The other two wafers were immersed into an aqueous fluoride salt based activator composition composed of 30 g/L ammonium fluoride and 10 g/L oxalic acid at room temperature. After immersion in the hydrofluoric acid for one minute, the silicon nitride turned from dark blue to brown indicating significant hydrofluoric acid attack. The silicon nitride coatings on the wafers which were immersed in the aqueous ammonium fluoride and oxalic acid composition did not show any observable change.

### Example 2 (comparative)

Two doped monocrystalline silicon wafers with a nickel silicide deposit were provided. Each doped silicon wafer had an n+ doped zone on the front side of the wafer forming an emitter layer and a pn-junction below the emitter layer. The front side of each wafer was coated with an antireflective layer composed of silicon nitride. The front side of each wafer had a pattern for current tracks through the antireflective layer. A nickel silicide deposit coated the surface of the current tracks. Each current track traversed the entire length of the wafer. The current tracks joined a bus bar at an end of each wafer and at the center of each wafer. The back side of each wafer was p+ doped.

The monocrystalline wafers were then taped along their edges to a plating rack using 3M Circuit Plating Tape™ 1280. The tape also protected the wafers from any potential undesired edge plating. Each wafer was immersed into an aqueous solution of 1wt% hydrofluoric acid for one minute to activate the nickel silicide. The mononcrystalline wafers were then immersed into an aqueous bath of ENLIGHT™ 1300 Electrolytic Nickel plating solution contained in a chemically inert plating cell. The nickel silicide coated current tracks were cathodically connected to a rectifier and a nickel electrode served as the anode. Plating temperature was 35° C. The current density was 2 A/dm². Nickel plating was done until a nickel layer 250nm thick was deposited on the nickel silicide.

The wafers were then removed from the nickel plating bath and immersed into a copper plating bath to plate the nickel layer with copper. A copper layer 30µm thick was plated on the nickel using ENLIGHT™ 460 Electrolytic Copper electroplating solution. The copper bath was 30° C and the current density was 5 A/dm². The wafers were removed from the copper bath and observed for plating quality. Plating was observed not just on the current tracks but both nickel and copper deposits were seen on portions of the wafers where the 1wt% hydrofluoric acid corroded the silicon nitride antireflective layer.

### Example 3

The method described in Example 2 was repeated except that the nickel silicide was activated for one minute at room temperature with an aqueous solution composed of 30 g/L ammonium fluoride and 10 g/L oxalic acid instead of hydrofluoric acid. The activated nickel silicide was then plated with 250nm nickel layer followed by plating the nickel layer with 30µm copper layer as described in Example 2. The two wafers were removed from the copper plating bath and observed for plating performance. Plating was observed only on the current tracks. There was no observable corrosion of the silicon nitride antireflective layer or metal plating outside of the areas of the current tracks.

### Example 4

Two doped monocrystalline silicon wafers were provided. Each doped silicon wafer had an n+ doped zone on the front side of the wafer forming an emitter layer and a pn-junction below the emitter layer. The front side of each wafer was coated with an antireflective composite layer composed of silicon oxide/silicon nitride. The front side of each wafer had a pattern for current tracks through the antireflective layer which exposed the surface of the silicon wafers. The exposed silicon had a layer of native silicon dioxide. Each current track traversed the entire length of the wafer. The current tracks joined a bus bar at an end of each wafer and at the center of each wafer. The back side of each wafer was p+ doped and contained an aluminum electrode.

The monocrystalline wafers were then taped along their edges to a plating rack using 3M Circuit Plating Tape™ 1280. The tape also coated the backside aluminum electrode and protected the wafers from any potential undesired edge plating. Each wafer was then immersed in an aqueous composition composed of 30 g/L of ammonium fluoride and 10 g/L of oxalic acid for 1 minute at room temperature to remove the native silicon dioxide on the exposed silicon surfaces. The wafers were then immersed into an aqueous bath of ENGLIGHT™ 1300 Electrolytic Nickel plating solution contained in a chemically inert plating cell which was transparent to light. The aluminum electrodes on the backside of the wafers were connected to a rectifier and a nickel electrode served as the anode. Plating temperature was 35° C. The current density was 0.5 A/dm². Artificial light was applied to the wafers throughout plating using a 250 watt incandescent lamp. Nickel plating was done until a nickel layer 250nm thick was deposited on the silicon of the current tracks.

Each plated wafer was then placed in a Sierra Therm furnace 7500 Series w/T-3 Qz. IR lamps to sinter the wafers and form nickel silicide. The temperature in the furnace was ramped from room temperature to 425° C over 10 seconds with a peak setting sintering temperature of 425° C for a period of 10 seconds. The speed at which the wafers passed through the furnace was 150 cm/minute.

After cooling, the wafers were then taped along their edges to a plating rack using 3M Circuit Plating Tape™ 1280. The tape also coated the backside aluminum electrode and protected the wafers from any potential undesired edge plating. The wafers were then placed in an aqueous composition composed of 30 g/L of ammonium fluoride and 10 g/L of oxalic acid for 1 minute at room temperature to activate the nickel silicide for metal plating. Each wafer was then plated with a 250nm nickel layer using ENGLIGHT™ 1300 Electrolytic Nickel plating solution by the same method described above.

The nickel layer on each wafer was then plated with a copper layer 10µm thick using ENLIGHT™ 460 Electrolytic Copper electroplating solution. Artificial light was applied to the wafers throughout plating using a 250 watt incandescent lamp. The aluminum electrodes were connected to a rectifier and a copper electrode functioned as the anode. The copper bath was 30° C and the current density was 2 A/dm².

The wafers were then immersed in ENLIGHT™ Silver Plate 620 cyanide-free silver electroplating solution. The aluminum backside electrodes were connected to a rectifier and a soluble silver electrode functioned as the anode. The temperature of the electroplating solution was 35° C. The 250 watt incandescent lamp was the source of artificial light. The current density was 2 A/dm² and plating was done until a silver layer 2µm thick was deposited in the copper.

The wafers were removed from the electroplating solution and observed for plating performance. Plating was only observed on the current tracks. There was no indication of corrosion of the antireflective layer or metal plating outside of the current tracks region. The adhesion of the metal layers was then tested using a solder/pull test. Solder flux was applied to a 1.5mm wide ribbon containing 62%Sn, 36%Pb and 2%Ag (available from Indium Corporation of America). The wafer was heated to 70° C on a isotemp basic ceramic hotplate and the ribbon was soldered onto the busbar of the wafers using a Weller WDI soldering iron applied at 360° C. A pull test was performed using GP STAB-TEST (available from GP Solar). The force determined to pull the metal layers from each wafer was greater than 4N indicating that the metal layers were acceptable for many commercial applications.

### Example 5 (comparative)

Two doped monocrystalline silicon wafers were provided. Each doped silicon wafer had an n+ doped zone on the front side of the wafer forming an emitter layer and a pn-junction below the emitter layer. The front side of each wafer was coated with an antireflective composite layer composed of silicon oxide/silicon nitride. The front side of each wafer had a pattern for current tracks through the antireflective layer which exposed the surface of the silicon wafers. The exposed silicon had a layer of native silicon dioxide. Each current track traversed the entire length of the wafer. The current tracks joined a bus bar at an end of each wafer and at the center of each wafer. The back side of each wafer was p+ doped and contained an aluminum electrode.

The wafers were then taped along their edges to a plating rack using 3M Circuit Plating Tape™ 1280. The wafers were then immersed into an aqueous bath of ENLIGHT™ 1300 Electrolytic Nickel plating solution contained in a chemically inert plating cell which was transparent to light. The aluminum electrodes on the backside of the wafers were connected to a rectifier and a nickel electrode served as the anode. Plating temperature was 35° C. The current density was 0.5 A/dm². Artificial light was applied to the wafers throughout plating using a 250 watt incandescent lamp. However, no nickel was observed on the exposed silicon current tracks even after 10 minutes of plating which was beyond the normal nickel plating cycle of 30 seconds to 2 minutes. The presence of the native oxide on the surface of the silicon wafers was believed to be the cause of the wafer plating failure.

### Example 6 (comparative)

Four doped monocrystalline silicon wafers were provided. Each doped silicon wafer had an n+ doped zone on the front side of the wafer forming an emitter layer and a pn-junction below the emitter layer. The front side of each wafer was coated with an antireflective composite layer composed of silicon oxide/silicon nitride. The front side of each wafer had a pattern for current tracks through the antireflective layer which exposed the surface of the silicon wafers. The exposed silicon had a layer of native silicon dioxide. Each current track traversed the entire length of the wafer. The current tracks joined a bus bar at an end of each wafer and at the center of each wafer. The back side of each wafer was p+ doped and contained an aluminum electrode.

The wafers were then taped along their edges to a plating rack using 3M Circuit Plating Tape™ 1280. Each wafer was immersed in an aqueous composition composed of 30 g/L of ammonium fluoride and 10 g/L of oxalic acid for 1 minute at room temperature to remove the native silicon dioxide on the exposed silicon surfaces. The wafers were then immersed into an aqueous bath of ENLIGHT™ 1300 Electrolytic Nickel plating solution contained in a chemically inert plating cell which was transparent to light. The aluminum electrodes on the backside of the wafers were connected to a rectifier and a nickel electrode served as the anode. Plating temperature was 35° C. The current density was 0.5 A/dm². Artificial light was applied to the wafers throughout plating using a 250 watt incandescent lamp. Nickel plating was done until a nickel layer 250nm thick was deposited on the silicon of the current tracks.

Each plated wafer was removed from the plating rack and then placed in a Sierra Therm furnace 7500 Series w/T-3 Qz. IR lamps to sinter the wafers and form nickel silicide. The temperature in the furnace was ramped from room temperature to 425° C over 10 seconds with a peak setting sintering temperature of 425° C for a period of 10 seconds. The speed at which the wafers passed through the furnace was 150 cm/minute.

After cooling, the wafers were then taped along their edges to a plating rack using 3M Circuit Plating Tape™ 1280. Each wafer was then plated with a 250nm nickel layer using ENLIGHT™ 1300 Electrolytic Nickel plating solution by the same method described above. The nickel layer on each wafer was then plated with a copper layer 10µm thick using ENLIGHT™ 460 Electrolytic Copper electroplating solution. Artificial light was applied to the wafers throughout plating using a 250 watt incandescent lamp. The aluminum electrodes were connected to a rectifier and a copper electrode functioned as the anode. The copper bath was 30° C and the current density was 2 A/dm².

The wafers were then immersed in ENLIGHT™ Silver Plate 620 cyanide-free silver electroplating solution. The aluminum backside electrodes were connected to a rectifier and a soluble silver electrode functioned as the anode. The temperature of the electroplating solution was 35° C. The 250 watt incandescent lamp was the source of artificial light. The current density was 2 A/dm² and plating was done until a silver layer 2µm thick was deposited on the copper.

The wafers were removed from the electroplating solution and observed for plating performance. Plating was only observed on the current tracks. There was no indication of corrosion of the antireflective layer.

The adhesion of the metal layers was then tested using Scotch transparent tape Cat.# 600. The tape was applied to the metal plated side of each wafer and then hand pulled from the wafer. The tape removed substantially all of the metal on the wafers indicating that adhesion was less than 1N. Since the wafers failed the tape test, the more rigorous solder/pull test could not be used to test the metal adhesion as in Example 4 above. As shown in Example 4 above, application of the aqueous fluoride and acid formulation to remove native oxide from the silicon followed by activating the nickel silicide with the same composition improves adhesion of the metals to the wafers.

### Example 7 (comparative)

Two monocrystalline silicon wafers with aluminum electrodes on their backside were weighed on a conventional Fischer Scientific weighing scale. Each wafer was then immersed for one minute in an aqueous solution of 1wt% hydrofluoric acid at room temperature. The wafers were removed from the solution rinsed with water and allowed to air dry. They were then reweighed. The weight loss was determined to be 0.5wt%. The weight loss was due to the corrosive action of the hydrofluoric acid on the aluminum electrodes.

### Example 8

The method described in Example 7 above was repeated except that the wafers were immersed in an aqueous composition composed of 30 g/L ammonium fluoride and 10 g/L oxalic acid instead of the hydrofluoric acid solution. The weight loss was determined to be only 0.1wt%. The corrosion of the aluminum electrodes was less when exposed to the aqueous composition composed of ammonium fluoride and oxalic acid than with the hydrofluoric acid solution of Example 7.

## Claims

1. A method comprising:
a) providing a substrate comprising silicon;
b) removing native oxide from a surface of the substrate with an aqueous activating composition composed of one or more sources of fluoride ions and one or more organic acids; and
c) depositing a metal layer on the substrate where the native oxide is removed.

2. The method of claim 1, further comprising sintering the metal layer and the substrate to form a metal silicide.

3. The method of claim 2, further comprising contacting the metal silicide with the aqueous activation composition composed of one or more sources of fluoride ions and one or more organic acids; and depositing one or more metal layers on the activated metal silicide.

4. The method of claim 3, further comprising stripping unreacted metal after silicide formation and prior to contacting the metal silicide with the aqueous activation composition.

5. The method of claim 1, wherein the metal is chosen from nickel, cobalt, palladium, platinum, rhodium and alloys thereof.

6. The method of claim 1, wherein a pH of the aqueous activation composition is 3 to less than 7.

7. The method of claim 3, wherein the one or more metal layers are chosen from silver, nickel, cobalt, palladium, platinum, gold, copper, rhodium, tin and alloys thereof.

8. The method of claim 1, wherein the substrate is a component of a solar cell, gate electrode, ohmic contact, interconnection line, Schottky barrier diode contact, a component of a photovoltaic device or an optoelectronic component.

9. A composition composed of one or more sources of fluoride ions, one or more organic acids and water.
